# EUROPEAN PATENT SPECIFICATION

(11) **EP 4 033 003 B1**
(45) Date of publication and mention of the grant of the patent: **01.11.2023**
(21) Application number: 21208104.6
(22) Date of filing: 13.11.2021
(51) Int. Cl.: C23C 14/08, C23C 14/35, H01L 21/02, C23C 14/00, C23C 14/54

(54) **METHOD FOR DEPOSITION OF YTTRIUM MONOXIDE FILM**
VERFAHREN ZUR ABSCHEIDUNG VON YTTRIUMMONOXIDFOLIEN
PROCÉDÉ DE DÉPÔT D'UN FILM DE MONOXYDE D'YTTRIUM

(30) Priority: 11.12.2020 LV 200090
(43) Date of publication of application: 27.07.2022
(73) Proprietor: Latvijas Universitates Cietvielu fizikas instituts, 1063 Riga (LV)
(72) Inventor: ARSLAN, Halil, 1010 Riga (LV)
(74) Representative: Fortuna, Jevgenijs

(56) References cited:
- KAMINAGA KENICHI ET AL: "A divalent rare earth oxide semiconductor: Yttrium monoxide", APPLIED PHYSICS LETTERS, A I P PUBLISHING LLC, US, vol. 108, no. 12, 21 March 2016 (2016-03-21), XP012206175, ISSN: 0003-6951, DOI: 10.1063/1.4944330 [retrieved on 1901-01-01]

## Description

### Field of the Invention

The invention relates to nanocoatings, more particularly, to nanocoatings deposited by plasma vacuum technologies and having semi-conducting properties.

### Background of the Invention

Yttrium element, a member of the rare earth metal family and has an exceptionally high affinity for oxygen, with a free energy of formation for the oxide of 1817 kJ mol⁻¹, is one of the most promising material for the microelectronic industry/superconducting material industry due to the fact that it's suitable dielectric level [1] and high/reasonable superconducting phase transition temperature (for detailed information of yttrium please notice table 1). YBCO is one of the most known zero resistance material on which many scientists has been working since in the middle of the 20^{th} century by the development of the thin film deposition methods such as laser ablation, e- beam evaporation, or magnetron sputtering [2]. Recent studies prove superconducting phase transition occurs above room temperature for YH₁₀ at 250 GPa [3]. Understanding the dynamics of the yttrium bonding with elements such as O, H and F is important for the future technology. Albeit a number of studies have examined the relationship between the Y and O atoms [4,5] for sequential oxidation only a couple of studies have been carried out in the investigation of the semiconducting yttrium monoxide (YO) [6,7].

Kenichi Kaminaga et al.[7] disclose a process for the deposition of yttrium monoxide wherein the method is a pulsed laser deposition method using a KrF excimer laser. Ar + 1% 02 is introduced during deposition and oxygen partial pressure is between 9×10⁻¹¹ to 2×10⁻⁸ Torr. However, to the best of author's knowledge, no report on the production of the semiconducting YO using DC magnetron sputtering has been found so far. The novelty of the current invention is depositing yttrium monoxide thin film with semi conducting behaviour by reactive DC magnetron sputtering.

### Summary of the Invention

The proposed novel method for deposition of yttrium monoxide (YO) film on a substrate by reactive magnetron sputtering, comprises the following steps: (i) positioning a substrate in a vacuum chamber having a magnetron and yttrium source for sputtered particles and a process gas shroud means for partially enveloping the magnetron, the substrate having a surface facing the source; (ii) operating the magnetron to sputter yttrium particles from the yttrium source for coating the substrate surface, including introducing a process gas to the shroud means; (iii) withdrawing and depleting gas from the vacuum chamber and creating process pressure between 1×10⁻³ and 5×10⁻³ Torr with 1.40×10⁻⁸ - 1.74×10⁵ Torr oxygen partial pressure by inletting the process gases and continuing sputtering yttrium particles from the yttrium source; as soon as the desired thickness of coating on the substrate surface is reached, disactivating the magnetron. According to an embodiment sputtering of yttrium particles from the yttrium source at the step (ii) is preferably made at the temperature from 290 to 630 K. According to another embodiment before the step (i) of positioning the substrate in the vacuum chamber, the vacuum chamber is heated for 1-48 hours at 80-110° C. According to yet another embodiment, at the step (i) of positioning the substrate in a vacuum chamber, the substrate is positioned so that its surface facing the source is located at an angle 30-70° to the magnetron and yttrium source. The process gas under the invention can be a mixture of Ar and O₂. According to the preferred embodiment the process gas is introduced to the shroud means with the following gas flow rates: P(Ar) / P(O₂): 500 - 800. According yet to another embodiment before positioning the substrate in a vacuum chamber at the step (i) the substrate is cleaned with acetone and isopropanol in ultrasonic bathes, rinsed with distilled water, and then dried under blown N₂ gas. There is also proposed a novel coating structure, comprising a substrate and yttrium monoxide (YO) coating layer disposed on the substrate, wherein the thickness of the yttrium monoxide coating layer is from 297 to 448 nm, wherein the substrate is selected from the group consisting of glass, polymer and metal.

### Brief Description of Drawings

- Figure 1 -: Reference X-ray diffractograms of the target material (Y metal) and Y₂O₃ powder.
- Figure 2 -: Reference X-ray diffractograms of the substrate materials used in the invention (Si, Ti, and Glass).
- Figure 3 -: X-ray diffractograms of the thin films deposited at 298.15 K on glass substrate.
- Figure 4 -: X-ray diffractograms of the thin films deposited at 623.15 K on glass substrate.
- Figure 5 -: X-ray diffractograms of the thin films deposited at 298.15 K on Si substrate.
- Figure 6 -: X-ray diffractograms of the thin films deposited at 623.15 K on Si substrate.
- Figure 7 -: X-ray diffractograms of the thin films deposited at 298.15 K on Ti substrate.
- Figure 8 -: X-ray diffractograms of the thin films deposited at 623.15 K on Ti substrate.
- Figure 9 -: Degree of crystallinity of the thin films deposited at 298.15 K.
- Figure 10 -: Degree of crystallinity of the thin films deposited at 623.15 K.
- Figure 11 -: Reference X-ray photoelectron spectroscopy (XPS) of Y metal target.
- Figure 12 -: Reference X-ray photoelectron spectroscopy (XPS) of Y₂O₃ powder.
- Figure 13 -: Debt profile investigation of the thin films deposited at 298.15 K.
- Figure 14 -: Debt profile investigation of the thin films deposited at 623.15 K.
- Figure 15 -: X-ray photoelectron spectroscopy (XPS): Y/O₂ ratio of metal Y, Y₂O₃ and YO.
- Figure 16 -: Transmittance measurements of the thin films deposited at 298.15 K in the range of UV-VIS and near-infred (NIR).
- Figure 17 -: Transmittance measurements of the thin films deposited at 623.15 K in the range of UV-VIS and NIR
- Figure 18 -: Tauc plot of the YO thin films.
- Figure 19 -: Absorbance measurements of YO thin films.
- Figure 20 -: Temperature dependent electrical measurements of the selected thin films.

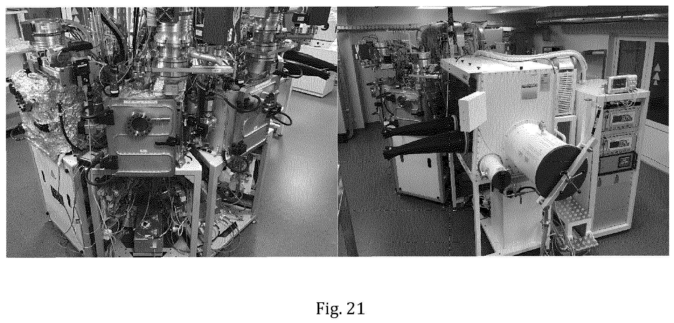

- Figure 21: shows representation of multi-functional cluster tool used in this invention.

### Detailed description of the invention

According to the preferred embodiment the vacuum chamber is heated for 1-48 hours at around 80-110°C with the purpose of decreasing possible contamination. The substrates are preferably cleaned, e.g. in an ultrasonic bath by Acetone, Isopropanol, and DI water respectively (for about 15 min. each) and dried with N₂ gas. The substrate is located some distance away from the target. The angle between the target and the substrate can be either about 180°, or from 30 to 70° to do an off-axis deposition. According to the preferred embodiment, a pre-sputtering can be made with the aim of removing the oxide layer on the target. The deposition of yttrium oxide thin films, 297-448nm in thickness, is done from metallic (purity 99.99%) target on to the substrate, which can be soda-lime glass, Ti, Si (001), or other material, at the temperature from 290 to 630 K. The partial pressure of O₂ can be varied between 1.74 × 10⁻⁵ and 1.4 × 10⁻⁸ Torr.

With the purpose of investigating the oxidation mechanism of yttrium, plasma was monitored during the process by means of the optical emission spectrometer and residual gas analyser. After the deposition, the samples can be directly transferred and stored in the Ar atmosphere (< 0.5 O₂ and H₂O ppm) glove-box by the robotic arm with the purpose of protecting the oxidization/contamination of the surface of the films.

According to one embodiment no post-treatment is applied to the films. Depending on the partial pressure of oxygen used during the deposition, the structural characterization (XRD) of the films shows metallic yttrium with a hexagonal structure and Y₂O₃ with a cubic/monoclinic structure (formation occurs by % 80 DOC). The formation of yttrium monoxide (YO) starts in this transformation region as an X-ray amorphous/nanocrystalline phase. The degree of crystallinity shows the formation of the novel semiconducting YO and depends on the substrate (lattice match/mismatch) and the growth temperature. Secondly, the ratio, by chemical characterization (XPS), between Y and O is determined around 1. Finally, the electrical measurement confirms the oxygen partial pressure at approximately 6.00 E-7 Torr is optimal for the semiconducting YO formation.

According to one embodiment the invention can be implemented using a reactive DC magnetron sputtering attached to the multi-functional cluster tool with individual (isolated) chambers. Chamber one is the place where the substrate is loaded into the cluster, chamber zero is the place of the robotic arm that takes charge of conveying the sample between chambers. The deposition, on the other hand, was carried out in chamber four. The chamber six, which is connected to the glove box, was used to unload the sample into the Ar atmosphere. The vacuum chamber was heated for 48 hours at around 95°C with the purpose of decreasing possible contamination and it was segregated, in order to stabilize the partial pressures of residual gases, from the climate of the cleanroom (ISO 8 class) during the whole experiment. The substrates were cleaned in an ultrasonic bath by acetone, isopropanol, and DI water respectively (15 min. each) and dried under the blow of N₂ gas. The substrate was located 13 cm away from the target. The angle between the target and the substrate was fixed at 45° to do an off-axis deposition. Before the experiment the pre-sputtering done with the aim of removing the oxide layer on the target. The residual gas analysis was done by means of a masspectrometer. The deposition of yttrium oxide thin films, around 400 nm in thickness, was done from metallic (purity 99.99%) target on to the soda-lime glass, Ti, and Si (001) substrates at 298.15 and 623.15 K. In order to obtain homogeneous thin films, the sample holder was rotated clockwise with 10 rpm. The partial pressure of O₂ was varied between 1.74 × 10⁻⁵ and 1.4 × 10⁻⁸ Torr to investigate the oxidation mechanism of the yttrium.

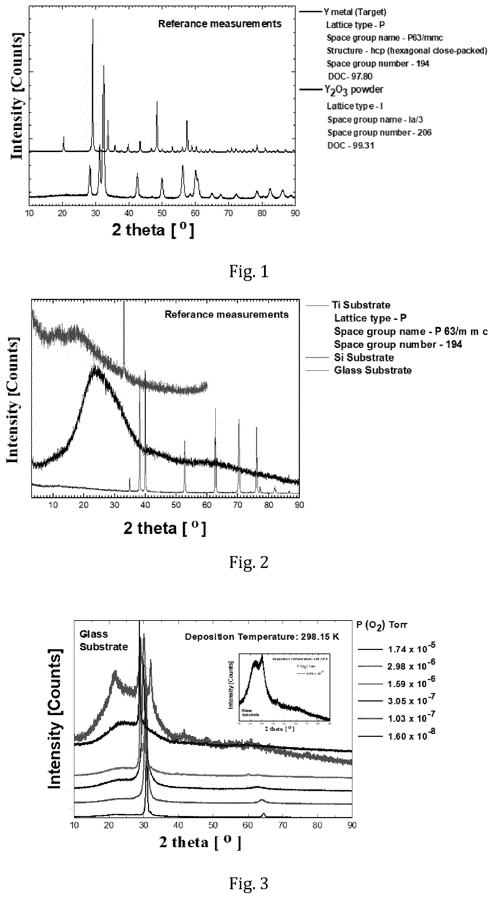

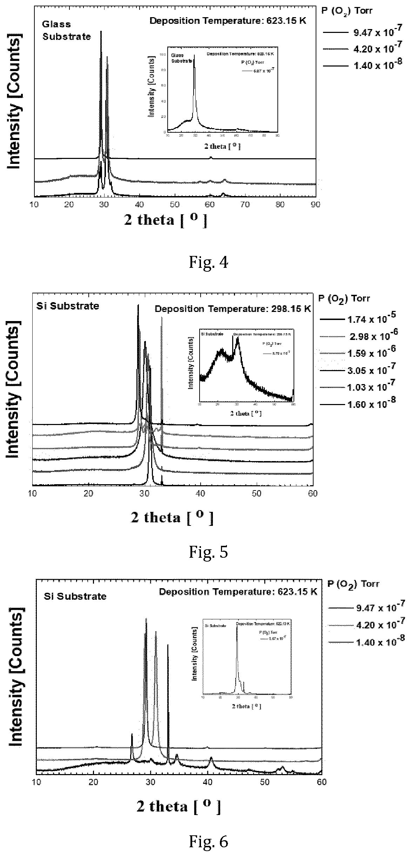

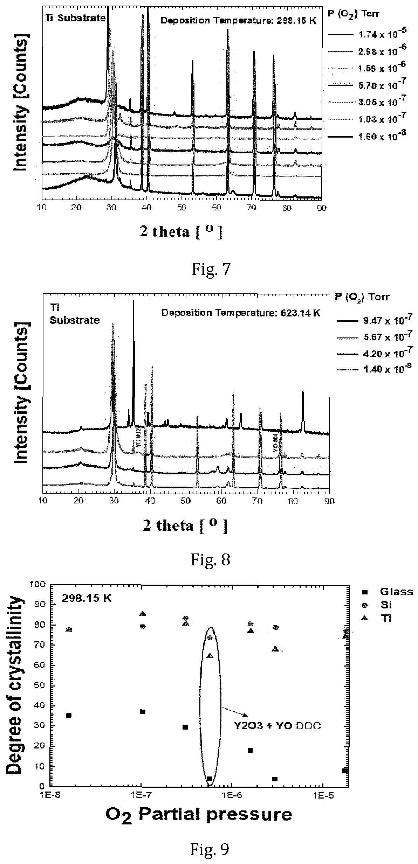

Structural Characterization. The structure of the films was studied by a Rigaku MiniFlex 600 benchtop X-ray diffractometer with the HyPix-400 MF 2D hybrid pixel array detector (HPAD) and a Cu X-ray source. To make the correct structural analysis the diffractograms of the reference materials were measured (Figure 1 and 2). Albeit the crystal structure of the metal yttrium and Y₂O₃ is well known [8,9] the behaviour of an yttrium monoxide still possess its ambiguity. The depositions were done onto different substrates with different crystal orientations. Depending on the partial pressure of O₂ and the temperature a transition from Y metal (hexagonal closed packed) to Y₂O₃ (body cantered cubic/monoclinic) is observed. The valance orbital of the yttrium (4d¹5s²) tends to be unstable as the phase revolves to monoxide (4d¹5s¹). That unstable behaviour stops the growth of the crystal (tends to form nanocrystal). This behaviour can be observed in figure 8. In addition, the formation of the yttrium element with different oxidation states tends to grow in the preferential directions was also proved in this invention (notice figures 1- 9). The formation of yttrium monoxide appears between the phase transformation from yttrium metal to Y₂O₃ (monoclinic/isomeric).

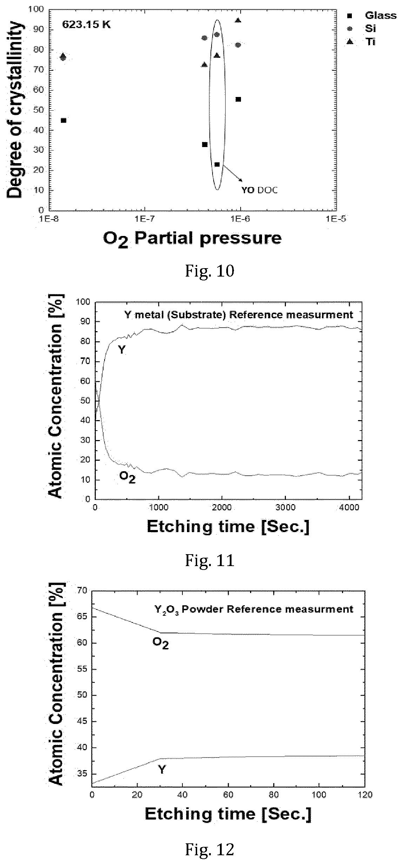

During the transformation, the XRD maximums corresponding to the specific crystal structure become broaden. At 29.075 and 32.415 (2θ) the most intense maximums are observed. Albeit the range of 30 - 34 2θ is the most inappropriate region for yttria (Y₂O₃), the same region possesses the most intense diffraction pattern for metal yttrium (please see the reference diffraction measurements in the figure1 and figure 8. For the sample (9.47×10⁻⁷ Torr O₂ partial pressure used) some forbidden peaks appear at for either Y₂O₃ and Y metal that can belong to yttrium monoxide (YO). Apart from that, one of the characteristic maximum stands for the yttria (Y₂O₃) appears around 20 2θ (See figures 3, 4, 7 and 8). That behaviour proves the crystal formation of yttrium monoxide is accompanied by yttria (as proved Kaminaga et al. [7]). Albeit the degree of the crystallization of the thin films shows similar trends on the different substrates at 298.15 K, it represents slightly different demeanour at the 623.15K (see the figures 9 and 10) which can be explained by the temperature conductivities of the materials are diverse. In the case of yttrium monoxide, the crystallization degree is around 20 %, 80% and 90 on the glass, Ti and Si substrates, respectively. That relatively low crystallization level on the glass may be the reason behind of the limited electrical conductivity. On the other hand, the high degree of crystallization on the Si and Ti substrates indicates, the formation of Y₂O₃ and YO has providential direction(s). Notice figures 1 - 8.

Optical Characterization. For the optical characterizations in the UV-VIS and NIR of the deposited thin films the Cary 7000 Spectrophotometer with the wavelength accuracy UV-VIS: +/- 0.08 nm, NIR: +/- 0.04 nm was used. The investigation was done as:
a- Transmission measurements in the range of 250 - 2500 nm wavelength P polarized light perpendicular to the substrate.
b- Reflectance measurements in the range of 250 - 2500 nm wavelength P polarized light ± 6° to the substrate.

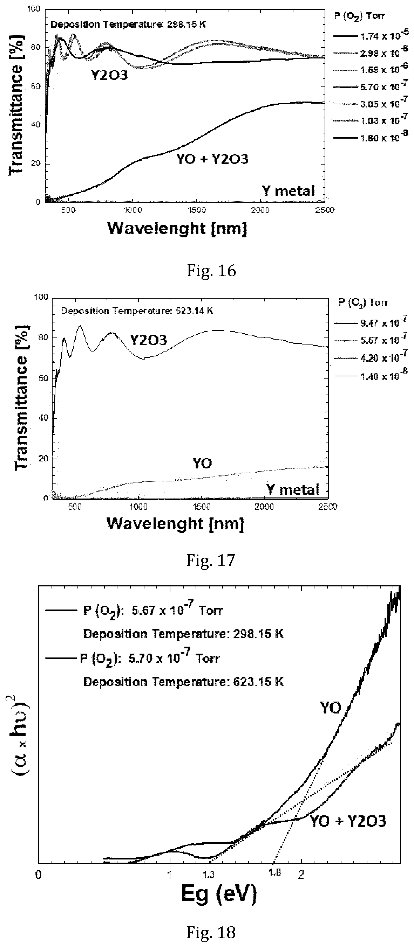

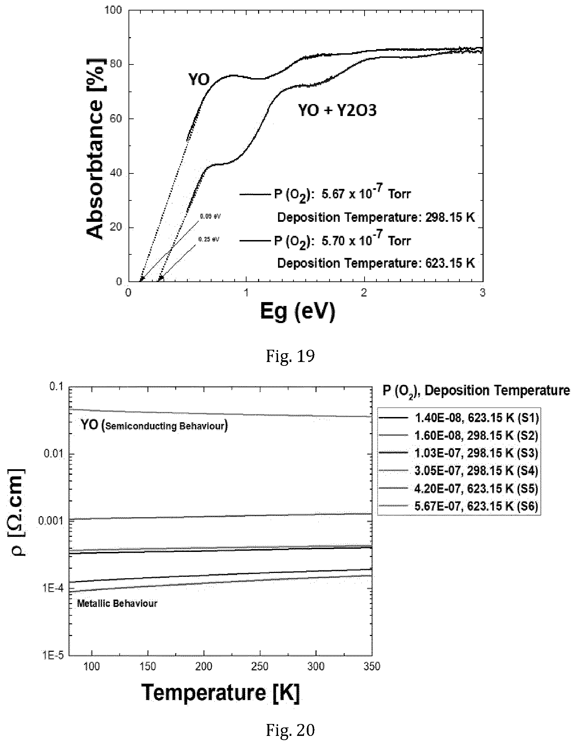

At 298.15 K deposited films are divided three main classes: transparent oxide, metallic and semi-transparent (see figure16,17). Y₂O₃ transmit the most of the electromagnetic wave in the visible region due to the large bandgap. The metal formation starts as the partial pressure of oxygen is lower than 5 E-07 Torr. On the other hand, in the very specific region (5 - 6 E-07 Torr) yttrium monoxide accompanies to the yttria formation. In the case of high temperature deposition (623.15 K), the crystallization of yttrium monoxide dominates the structure resulting into semiconducting behaviour (notice figure 20). Apart from that the interference of the electromagnetic radiation is noticeable in the spectrum of both Y₂O₃ and YO/Y₂O₃. This demeanour results into the fluctuation of the spectrum. The optical band gap of the thin films with the formation of YO are computed (see the figures 18 and 19). The determined band gap of the YO shows consistence with the literature [7].

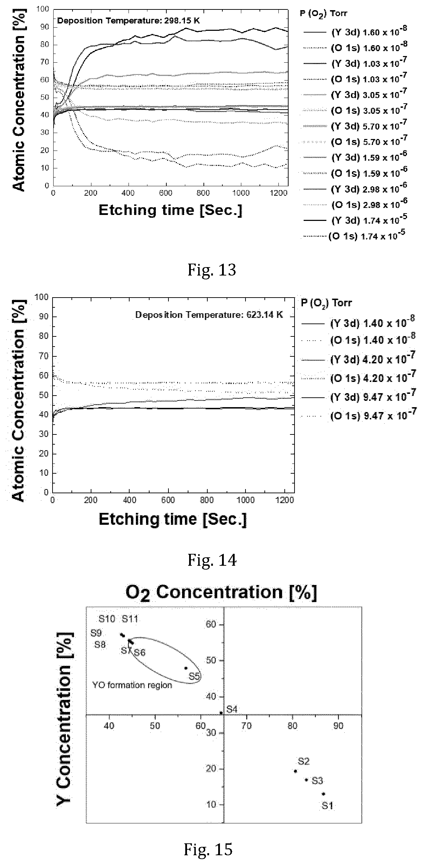

Chemical Characterization. The chemical composition (either qualitative or quantitative) of the materials of interest the ESCALAB Xİ, X-ray photoelectron spectroscopy equipped with Al x-ray source (Al Kα =1487 eV) by ThermoFisher was employed. The debt profiles of atomic concentrations and binding energies (gives direct information about the oxidation state) of the elements of interest (yttrium and O₂, in the present case) are investigated through the thin films. Depending on the partial pressure of O₂ a shift from Metallic to Yttria (Y₂O₃) was observed. In addition, Yttrium monoxide phase with semi conducting behaviour was observed (see figures 15 and 20). The variation, that may directly affect the area under the graph/the concentration of the element, in the binding energies of Y 3d may results from the polarization of the cation during/after the Ar ion bombardment [10]. The observed results for YO show the correspondence with the literature [7].

Electrical Characterization. The electrical measurements of the materials of interest the Hall measurement system 5000, Ecopia was employed. The measurements were carried out in the range of 80 - 350 K by 10 K step. The temperature dependent electric measurement of a material gives the direct information to which material class it belongs. In more detail, due to the fact the increase in the amplitude of the vibration of the phonons by temperature there happens a decrease in the mean free path of the charge carriers (electrons) that results in an increase in the resistivity for metals. On the other hand, in the case of semi conducting materials increase in the temperature leads more electron transfer from the valance band to the conduction band because of this the conductivity of the material shows an increasing demeanour. Yttrium represents low resistivity. YzOa is a good insulator due to the large band gap, (Notice table 1). The results of the temperature dependent electrical measurements of the selected thin films are shown on figure 20.

Further tables summarize additional information on the deposition parameters and physical properties of the films grown according to some embodiments, where table 1 discloses some deposition parameters of the films grown and the table 2 discloses a list of the physical properties of the Yttrium element.

**Table 1. Basic properties of yttrium element ^{10,11,20-29,12,30-39,13,40-49,14,50-59,15,60-69,16-19}.**

| **Yttrium Atomic Structure** | | Yttrium Thermodynamics | | **Yttrium Atomic Interaction** | |
|---|---|---|---|---|---|
| **Ionization Energies** | | **Melting Point** | 1795.15 K | *Oxidation States* | 3 |
| *I (1)* | 6.2173 eV | **Boiling Point /1 atm** | 3618.15 K | | 2 |
| *II* (2) | 12224 eV | **Thermal Conductivity solid** | | **Pauling Electronegativity /oxidation state: 3** | 1.22 |
| *III (3)* | 20.52 eV | *400 K. Polycrystalline* | 18.0 W/(m K) | | |
| *IV (4)* | 60.597 eV | *300 K. Polycrystalline* | 17.2 W/(m K) | **Sanderson Electronegativity** | |
| **Electron Affinity** | 0.307 ± 0.012 eV | *298.2 K, Polycrystalline* | 172 W/(m K) | *Oxidation State: 3* | 0.65 |
| | 2480 ± 100 cm-1 | *273.2 K, Polycrystalline* | 17.0 W/(m K) | *Oxidation State* 2 | 0.4 |
| **Electron Binding Energies** | | *200 K, Polycrystalline* | 16.6 W/(m K) | **Allred-Rochow Electronegativity** | |
| *K (1s)* | 17038 eV | ***Critical Point*** | 8950 K | *Oxidation State:* 3 | 1.11 |
| *LI (2s)* | 2373 eV | **Vapor Pressure** | | **Configuration Energy** | |
| *LII (2p1*/*2)* | 2156 eV | 3334 °C | 100 kPa | *Electron Volt Units* | 6.631 eV |
| *LIII (2p3*/*2*) | 2080 eV | 2763 °C | 10 kPa | *Pauling Units* | 1.12 |
| **Electron Configuration** | | 2354 °C | 1 kPa | **Allred Electronegativity** | |
| *Orbital Occupancy* | [Kr] 4d1 5s2 | 2047 °C | 100 Pa | *Oxidation State: 3* | 1.22 |
| *Orbital Filling Order* | [Kr] 5s2 4d1 | 1802.3 °C | 10 Pa | **Ghosh-Gupta Electronegativity** | 2.7237 eV |
| *Term Symbol* | 2D3/2 | 1610.1 °C | 1 Pa | **Nagle Electronegativity** | 1.11 |
| **Clementi-Raimondi Effective Nuclear Charge** | | **Enthalpy of Fusion (1 atm)** | 172 kJ/mol | **Pearson Absolute Electronegativity** | 3.19 eV |
| **1s** | | **Enthalpy of Vaporization (1 atm)** | 393.3 kJ/mol | **Smith Electronegativity** | |
| *Orbital Exponent* | 38.1756 | **Isobaric Molar Heat Capacity 298.15 K, 1 bar** | 26.53 J/(mol K) | *Oxidation State: 3* | 1.2 |
| *Principle Quantum Number* | 1 | | | **Chemical Hardness** | 3.19 eV |
| *Effective Nuclear Charge* | 38.1756 | **Isobaric Specific Heat Capacity 298.15 K, 1 bar** | 0.298 J/(g K) | **Cohesive Energy** | |
| **2s** | | | | *Per Mole* | 422 kJ/mol |
| *Orbital Exponent* | 143111 | **Electronic Heat Capacity Coefficient** | 8.2 mJ/(mol K2) | *Per Atom* | 4.37 eV/atom |
| *Principle Quantum Number* | *2* | **Debye Temperature** | | **Yttrium Atomic Size** | |
| *Effective Nuclear Charve* | 286222 | *Room Temperature* (298 *K)* | 214 K | *Atomic Radius* | 182 pm |
| 5s | | *Low Temperature Limit ( 0 K)* | 248 K | *Orbital Radius* | 169.3 pm |
| *Orbital Exponent* | 1.251 | **Yttrium Physical Properties** | | ***Pyykkö Covalent Radius*** | |
| *Principle Quantum Number* | 5 | Density | | *Single Bond* | 163 pm |
| *Effective Nuclear Charge* | 6.256 | *Liquid, 1795.15 K* | 4.240 g/ml | *Double Bond* | 130 pm |
| 4d | | *Solid,* 25 °C | 4.469 g/cm3 | *Triple Bond* | 124 pm |
| *Orbital Exponent* | 3.989 | **Molar Mass** | | **Cordero Covalent Radius** | 190 pm |
| *Principle Quantum Number* | 4 | *Rounded* | 88.91 g/mol | **Shannon-Prewitt Crystal Radius ion charge: +3** | |
| *Effective Nuclear Charge* | 15.958 | *Standard* | 88.90585 ± 0.00002 g/mol | | |
| **Screening Percentage** | 0.914 | **Molar Volume (solid,298 K, 1 atm)** | 1988 cm3/mol | *Coordination Number. 6* | 104.0 pm |
| **Fluorescence Yields** | | **Physical Form** | silvery metal | *Coordination Number. 7* | 110 pm |
| *ωK* | 0.716 | **Linear Thermal Expansion Coefficient (25 °C)** | 10.6×10-6 K-1 | *Coordination Number. 8* | 115.9 pm |
| *ωL1* | 0.0059 | **Speed of Sound (solid, 293 K)** | 3300 m/s | *Coordination Number. 9* | 121.5 pm |
| *ωL2* | 0.026 | **Specific Gravity** | 4.47 | **Shannon-Prewitt Effective Ionic Radius ion charge: +3** | |
| *ωL3* | 0.028 | **68 °F, water at 4 °C (39.2 °F)** | | | |
| **Coster-Kronig Yields** | | **Young's Modulus** | 63.5 GPa | *Coordination Number. 6* | 90.0 pm |
| *F12* | 0.26 | **Poisson's Ratio** | 0.243 | *Coordination Number. 7* | 96 pm |
| *F13* | 0.57 | **Electrical Resistivity (solid, 295 K)** | 58 5×10-8 Ohm.m | *Coordination Number. 8* | 1019 pm |
| *F23* | 0.094 | **Superconducting Transition Temperature** | | *Coordination Number. 9* | 107.5 pm |
| **Yttrium Crystal Structure** | | *115* GPa | 19.5 K | **Pauling Empirical Crystal Radius ion charge: +3** | **93 pm** |
| *Allotrope* | α-yttrium | *89.3 GPa* | 17 K | | |
| *Symbol* | aY | *30 GPa* | 3.5 K | **Pauling Univalent Radius ion charge: +1** | **120 pm** |
| *Allotrope* | β-yttrium | **Isothermal Bulk Modulus (300 K)** | 36.6 GPa | | |
| *Symbol* | βY | **Isothermal Compressibility (300 K)** | 0.0273 GPa-1 | | |
| ***Nearest Neighbor Distance (300 K, 1 atm)*** | **355 pm** | **Gram Atomic Volume** | 21 cm3 | | |
| ***Atomic Concentration (300 K, 1 atm)*** | **302×1022 cm-3** | | | | |

**Table 2. Deposition parameters and basic characteristics of the produced thin films.**

| **Sample name** | **P (O₂)** | **P (Ar)** | **P (Ar) / P (02)** | **Deposition Temperature (K)** | **Power (cm 2)** | **Voltage** | **Current** | **Thickness (nm)** | **Deposition Rate (nm)** |
|---|---|---|---|---|---|---|---|---|---|
| | | | | | | | | | |
| **S1** | 1.40E-08 | 4.59E-04 | 32786 | 623.15 | 7.4 | 348 | 423 | 448 | 17.92 |
| **S2** | 1.60E-08 | 4.80E-04 | 30000 | 298.15 | 7.4 | 342 | 437 | 297 | 11.80 |
| **S3** | 1.03E-07 | 3.48E-04 | 3379 | 298.15 | 7.4 | 356 | 413 | 387 | 15.48 |
| **S4** | 3.05E-07 | 3.28E-04 | 1075 | 298.15 | 7.4 | 356 | 418 | 418 | 16.72 |
| **S5** | 4.20E-07 | 4.23E-04 | 1007 | 623.15 | 7.4 | 352 | 426 | 427 | 17.08 |
| **S6** | 5.67E-07 | 3.69E-04 | 650.8 | 623.15 | 7.4 | 360 | 416 | 400 | 16.00 |
| **S7** | 5.70E-07 | 3.61E-04 | 633.3 | 298.15 | 7.4 | 354 | 424 | 425 | 17.00 |
| **S8** | 9.47E-07 | 3.68E-04 | 388.6 | 623.15 | 7.4 | 356 | 422 | 430 | 17.20 |
| **S9** | 1.59E-06 | 3.07E-04 | 193.1 | 298.15 | 7.4 | 354 | 422 | 419 | 16.76 |
| **S10** | 2.98E-06 | 2.94E-04 | 98.66 | 298.15 | 7.4 | 341 | 438 | 420 | 16.80 |
| **S11** | 1.74E-05 | 2.66E-04 | 15.29 | 298.15 | 7.4 | 331 | 467 | 249 | 09.96 |

### References

1. Wang, Z. *et al.* Growth and performance of yttrium oxide as an ideal high-κ gate dielectric for carbon-based electronics. *Nano Lett.* (2010) doi:10.1021/nl100022u.
2. Tate, J., Berberich, P., Dietsche, W. & Kinder, H. Preparation and characterization of YBCO thin films on silicon. J. Less-Common Met. (1989) doi:10.1016/0022-5088(89)90332-9.
3. Liu, H., Naumov, I. I., Hoffmann, R., Ashcroft, N. W. & Hemley, R. J. Potential high-Tc superconducting lanthanum and yttrium hydrides at high pressure. Proc. Natl. Acad. Sci. U. S. A. (2017) doi:10.1073/pnas.1704505114.
4. Xu, L. et al. Structural evolution, sequential oxidation and chemical bonding in tri-yttrium oxide clusters: Y3Ox- and Y3Ox (x = 0-6). RSCAdv. (2014) doi:10.1039/c4ra09202c.
5. Dai, B., Deng, K. & Yang, J. A theoretical study of the Y4O cluster. Chem. Phys. Lett. (2002) doi:10.1016/S0009-2614(02)01330-1.
6. Stellhorn, J. R. et al. A valence-selective X-ray fluorescence holography study of an yttrium oxide thin film. J. Appl. Crystallogr. (2017) doi:10.1107/S1600576717012821.
7. Kaminaga, K. et al. A divalent rare earth oxide semiconductor: Yttrium monoxide. Appl. Phys. Lett. (2016) doi:10.1063/1.4944330. (XP012206175)
8. Zhang, P. et al. Energetics of cubic and monoclinic yttrium oxide polymorphs: Phase transitions, surface enthalpies, and stability at the nanoscale. J. Phys. Chem. C (2008) doi:10.1021/jp7102337.
9. Jankowski, A. F., Schrawyer, L. R. & Hayes, J. P. Sputter deposition of yttriumoxides. J. Vac. Sci. Technol. A Vacuum, Surfaces, Film. (1993) doi:10.1116/1.578503.
10. Orem, W. H. & Finkelman, R. B. Coal Formation and Geochemistry. in Treatise on Geochemistry: Second Edition (2013). doi:10.1016/B978-0-08-095975-7.00708-7.
11. Book Review of Materials Handbook: A Concise Desktop Reference, 2nd ed. Materials Handbook: A Concise Desktop Reference, 2nd ed. By Francois Cardarelli (Materials and Electrochemical Research (MER) Corp., Tucson, AZ). Springer-Verlag: London Limited . 20*.* J. Am. Chem. Soc. (2008) doi:10.1021/ja805138a.
12. Nomenclature of Inorganic Chemistry. IUPAC Recommendations 2005 Prepared for publication by Neil G. Connelly (University of Bristol, UK), Ture Damhas (Novozymes A/S, Denmark), Richard M. Hartshorn (University of Canterbury, New Zealand), and Alan T. Hutto. J. Am. Chem. Soc. (2006) doi:10.1021/ja069710g.
13. AIP physics desk reference. Choice Rev. Online (2003) doi:10.5860/choice.41-0669.
14. Kittel, C. Introduction to Solid State Physics, 8th edition. Wiley Sons, New York, NY (2004).
15. CRC Handbook of Chemistry and Physics, 88th ed Editor-in-Chief: David R. Lide (National Institute of Standards and Technology) CRC Press/Taylor & Francis Group: Boca Raton, FL. 2007. 2640 pp. $139.95. ISBN 0-8493-0488-1. J. Am. Chem. Soc. (2008) doi:10.1021/ja077011d.
16. The nature of the chemical bond and the structure of molecules and crystals, by Linus Pauling. 2nd Edition. xvi + 450 pages. Cornell University Press, Ithaca, N. Y., 1940. Price, $4.50. J. Am. Pharm. Assoc. (Scientific ed.) (1941) doi:10.1002/jps.3030300111.
17. (SGTE), S. G. T. E. Thermodynamic Properties of Inorganic Materials. Pure Substances. Part 1: Elements and Compounds from AgBr to Ba3N2. Numerical Data and Functional Relationships in Science and Technology (1999).
18. Allred, A. L. Electronegativity values from thermochemical data. J. Inorg. Nucl. Chem. (1961) doi:10.1016/0022-1902(61)80142-5.
19. Allred, A. L. & Rochow, E. G. A scale of electronegativity based on electrostatic force. J. Inorg. Nucl. Chem. (1958) doi:10.1016/0022-1902(58)80003-2.
20. Anders, E. & Grevesse, N. Abundances of the elements: Meteoritic and solar. Geochim. Cosmochim. Acta (1989) doi:10.1016/0016-7037(89)90286-X.
21. Andersen, T., Haugen, H. K. & Hotop, H. Binding Energies in Atomic Negative Ions: III. J. Phys. Chem. Ref. Data (1999) doi:10.1063/1.556047.
22. Batsanov, S. S. Inorganic Materials, Volume 37, Number 9 - SpringerLink. Inorg. Mater. (2001).
23. Benfey, O. T. & Ihde, A. J. The Development of Modern Chemistry. Technol. Cult. (1966) doi:10.2307/3102093.
24. Campbell, J. L. Fluorescence yields and Coster-Kronig probabilities for the atomic L subshells. At. Data Nucl. Data Tables (2003) doi:10.1016/S0092-640X(03)00059-7.
25. Clementi, E., Raimondi, D. L. & Reinhardt, W. P. Atomic screening constants from SCF functions. II. Atoms with 37 to 86 electrons. J. Chem. Phys. (1967) doi:10.1063/1.1712084.
26. Cordero, B. et al. Covalent radii revisited. J. Chem. Soc. Dalt. Trans. (2008) doi:10.1039/b801115j.
27. Cronan, D. S. Basal metalliferous sediments from the eastern Pacific. Bull. Geol. Soc. Am. (1976) doi:10.1130/0016-7606(1976)87<928:BMSFTE>2.0.CO;2.
28. de Podesta, M. & de Podesta, M. Background theory. in Understanding the Properties of Matter (2020). doi:10.1201/9781315274751-2.
29. Debessai, M., Hamlin, J. J. & Schilling, J. S. Comparison of the pressure dependences of Tc in the trivalent d -electron superconductors Sc, Y, La, and Lu up to megabar pressures. Phys. Rev. B - Condens. Matter Mater. Phys. (2008) doi: 10.1103 jPhysRevB. 78.064519.
30. Dronskowski, R. Computational Chemistry of Solid State Materials: A Guide for Materials Scientists, Chemists, Physicists and others. Computational Chemistry of Solid State Materials: A Guide for Materials Scientists, Chemists, Physicists and others (2007). doi:10.1002/9783527612277.
31. GALASSO, F. S. INTRODUCTION. in Structure and Properties of Inorganic Solids (1970). doi:10.1016/b978-0-08-006873-2.50004-4.
32. Ghosh, D. C. & Gupta, K. A new scale of electronegativity of 54 elements of periodic table based on polarizability of atoms. J. Theor. Comput. Chem. (2006) doi:10.1142/S0219633606002726.
33. Greenwood, N. & Earnshaw, A. 24 - Manganese, Technetium and Rhenium BT - Chemistry of the Elements (Second Edition). Chem. Elem. (1997).
34. Hamlin, J. J., Tissen, V. G. & Schilling, J. S. Superconductivity at 17 K in yttrium metal under nearly hydrostatic pressures up to 89 GPa. Phys. Rev. B - Condens. Matter Mater. Phys. (2006) doi:10.1103/PhysRevB.73.094522.
35. Herrmann, G. Book Review: Table of Isotopes. 8th Edition, Volumes 1 and 2. Edited by R. B. Firestone and V. S. Shirley. Angew. Chemie Int. Ed. English (1997) doi:10.1002/anie.199723842.
36. Ho, C. Y., Powell, R. W. & Liley, P. E. Thermal Conductivity of the Elements: A Comprehensive Review. Journal of Physical and Chemical Reference Data (1974).
37. Horvath, A. L. Critical temperature of elements and the periodic system. J. Chem. Educ. (1973) doi:10.1021/ed050p335.
38. John, E. An A-Z Guide to The Elements. Oxford Univ. Press (2001).
39. Kauffman, G. B. Discovery of the Elements. Mary Elvira Weeks. Seventh edition, revised and with new material added by Henry M. Leicester. Illustrations collected by F. B. Dains. Journal of Chemical Education, Easton, Pa., 1968. x + 896 pp. $12.50. Science (80-. ). (1968) doi:10.1126/science.162.3849.110-b.
40. Kauffman, G. B. Inorganic Chemistry, 2nd Ed. By Gary L. Miessler and Donald A. Tarr. Prentice-Hall: Upper Saddle River, NJ, 1999. Figures, tables, charts. xiv + 642 pp, 21.0 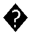 26.0 cm. $92.00. ISBN 0-13-841891-8 (Photo reproduced with permission from Prentice-Hall, Inc). *Chem. Educ.* (1999) doi:10.1007/s00897990322a.
41. Kaufman, G. B. Inorganic chemistry: principles of structure and reactivity, 4th ed. (Huheey, James E.; Keiter, Ellen A.; Keiter, Richard L.). J. Chem. Educ. (1993) doi:10.1021/ed070pa279.1.
42. Krause, M. O. Atomic radiative and radiationless yields for K and L shells. J. Phys. Chem. Ref. Data (1979) doi:10.1063/1.555594.
43. Li, Y. H. & Schoonmaker, J. E. Treatise on Geochemistry-7.01-Chemical Composition and Mineralogy of Marine Sediments. Treatise on Geochemistry: Second Edition (2003).
44. Liboff, R. L., Peebles, P. J. & Finkelstein, D. Introductory Quantum Mechanics and Quantum Mechanics . Phys. Today (1993) doi:10.1063/1.2808872.
45. Mann, J. B., Meek, T. L., Knight, E. T., Capitani, J. F. & Allen, L. C. Configuration energies of the d-block elements. J. Am. Chem. Soc. (2000) doi:10.1021/ja9928677.
46. Manuel, O. Origin of Elements in the Solar System. in Origin of Elements in the Solar System (2002). doi:10.1007/0-306-46927-8_44.
47. McDonough, W. F. Compositional Model for the Earth's Core. in Treatise on Geochemistry: Second Edition (2013). doi:10.1016/B978-0-08-095975-7.00215-1.
48. Moore, C. E. Ionization potentials and ionization limits derived from the analyses of optical spectra. Natl. Stand. Ref. Data Ser. (1970).
49. Nagle, J. K. Atomic Polarizability and Electronegativity. J. Am. Chem. Soc. (1990) doi:10.1021/ja00168a019.
50. Oxtoby, David W. Gillis H. P. Campion, A. Principles of Modern Chemistry. Inorganic Chemistry (2008).
51. Palme H & O'Neill H St C. Cosmochemical Estimates of Mantle Composition. in Treatise on Geochemistry: The Mantle and Core (2004).
52. Palme, H. & Beer, H. 3.4.8 Meteorites and the composition of the solar photosphere, in Instruments, Methods, Solar System (2005). doi:10.1007/10057790_59.
53. Pyykkö, P. & Atsumi, M. Molecular double-bond covalent radii for elements LiE112. Chem. -A Eur. J. (2009) doi:10.1002/chem.200901472.
54. Rabe, K. M. Atomic and Electronic Structure of Solids Atomic and Electronic Structure of Solids, Efthimios Kaxiras Cambridge U. Press, New York, 2003. $110.00, $65.00 paper (676 pp.). ISBN 0-521-81010-8, ISBN 0-521-52339-7 paper . Phys. Today (2004) doi:10.1063/1.1752432.
55. Ringnes, V. Origin of the names of chemical elements. J. Chem. Educ. (1989) doi:10.1021/ed066p731.
56. Rohrer, G. S. Structure and Bonding in Crystalline Materials. Structure and Bonding in Crystalline Materials (2001). doi:10.1017/cbo9780511816116.
57. Samsonov, G. V. & Straumanis, M. E. Handbook of the Physicochemical Properties of the Elements Phys. Today (1968) doi:10.1063/1.3035172.
58. Sansonetti, J. E. & Martin, W. C. Handbook of basic atomic spectroscopic data. J. Phys. Chem. Ref. Data (2005) doi:10.1063/1.1800011.
59. Schwedt, G. The Elements-Their Origin, Abundance and Distribution. Von P. A. Cox. Oxford University Press, Oxford 1989. VIII. 207 S., Broschur £ 9.95. - ISBN 0-19-855298-X. Angew. Chemie (1990) doi:10.1002/ange.19901020641.
60. Shannon, R. D. Revised effective ionic radii and systematic studies of interatomic distances in halides and chalcogenides. Acta Crystallogr. Sect. A (1976) doi:10.1107/S0567739476001551.
61. Slater, J. C. Atomic radii in crystals. J. Chem. Phys. (1964) doi:10.1063/1.1725697.
62. Smith, D. W. Inorganic reactions and their mechanisms. in Inorganic Substances (2010). doi:10.1017/cbo9780511622922.010.
63. Tari, A. The Specific Heat of Matter of Low Temperatures. The Specific Heat of Matter at Low Temperatures (2003). doi:10.1142/p254.
64. Waber, J. T. & Cromer, D. T. Orbital radii of atoms and ions. J. Chem. Phys. (1965) doi:10.1063/1.1695904.
65. Wagman, D. D. et al. The NBS Tables of Chemical Thermodynamic Properties. Journal of Physical and Chemical Reference Data (1982).
66. Waldron, K. A., Fehringer, E. M., Streeb, A. E., Trosky, J. E. & Pearson, J. J. Screening percentages based on Slater effective nuclear charge as a versatile tool for teaching periodic trends. J. Chem. Educ. (2001) doi:10.1021/ed078p635.
67. Wieser, M. E. & Coplen, T. B. Atomic weights of the elements 2009 (IUPAC technical report). in Pure and Applied Chemistry (2011). doi:10.1351/PAC-REP-10-09-14.
68. Yaws, C. L. Thermophysical Properties of Chemicals and Hydrocarbons: Second Edition. Thermophysical Properties of Chemicals and Hydrocarbons: Second Edition (2014). doi:10.1016/C2013-0-12615-3.
69. Yaws, C. L. Liquid density of the elements. Chem. Eng. (2007).

## Claims

1. A method for deposition of yttrium monoxide (YO) film on a substrate by reactive magnetron sputtering, comprising the following steps:
(i) positioning a substrate in a vacuum chamber having a magnetron and yttrium source for sputtered particles and a process gas shroud means for partially enveloping the magnetron, the substrate having a surface facing the source;
(ii) operating the magnetron to sputter yttrium particles from the yttrium source for coating the substrate surface, including introducing a process gas to the shroud means;
(iii) withdrawing and depleting gas from the vacuum chamber and creating process pressure between 1×10⁻³ and 5×10⁻³ Torr with 1.40×10⁻⁸ - 1.74×10⁻⁵ Torr oxygen partial pressure by inletting the process gases and continuing sputtering yttrium particles from the yttrium source; as soon as the desired thickness of coating on the substrate surface is reached, disactivating the magnetron.

2. The method according to claim 1, wherein sputtering of yttrium particles from the yttrium source at the (ii) step is made at the temperature from 290 to 630 K.

3. The method according to any preceding claims, wherein before the (i) step of positioning the substrate in the vacuum chamber, the vacuum chamber is heated for 1-48 hours at 80-110° C.

4. The method according to any preceding claims, wherein at the (i) step of positioning the substrate in a vacuum chamber, the substrate is positioned so that its surface facing the source is located at an angle 30-70° to the magnetron and yttrium source.

5. The method according to any preceding claims, wherein the process gas is a mixture of Ar and O₂.

6. The method according to any preceding claims, wherein the process gas is introduced to the shroud means with the following gas flow rates: P(Ar) / P(O₂): 500 - 800.

7. The method according to any preceding claims, wherein before positioning the substrate in a vacuum chamber at the step (i) the substrate is cleaned with acetone and isopropanol in ultrasonic bathes, rinsed with distilled water, and then dried under blown N₂ gas.

## Patentansprüche

1. Verfahren zur Beschichtung eines Substrats mit einem Yttriummonoxid (YO)-Film durch reaktives Magnetron-Sputtern, das die folgenden Schritte umfasst:
(i) Positionierung eines Substrats in einer Vakuumkammer mit einer Magnetron- und Yttriumquelle für gesputterte Teilchen und einer Prozessgasabschirmung zum teilweisen Umhüllen des Magnetrons, wobei das Substrat eine der Quelle zugewandte Oberfläche aufweist;
(ii) Steuern des Magnetrons zum Zerstäuben von Yttriumpartikeln aus der Yttriumquelle, damit sie die Substratoberfläche beschichten, einschließlich Zuführen eines Prozessgases für die Umhüllung;
(iii) Entnahme und Leerung von Gas aus der Vakuumkammer, und Erzeugung eines Prozessdrucks zwischen 1 × 10⁻³ und 5 × 10⁻³ Torr mit einem Sauerstoffpartialdruck von 1,40 × 10⁻⁸ - 1,74 × 10⁻⁵ Torr durch Einlassen der Prozessgase und fortgesetzte Zerstäubung von Yttriumpartikeln aus der Yttriumquelle. Sobald die gewünschte Schichtdicke auf der Substratoberfläche erreicht ist - Deaktivierung des Magnetrons.

2. Verfahren nach Patentanspruch 1, wobei das Sputtern von Yttriumpartikeln aus der Yttriumquelle im Schritt (ii) bei einer Temperatur von 290 bis 630 K erfolgt.

3. Verfahren nach einem der vorhergehenden Patentansprüche, wobei vor dem (i) Schritt, in dem das Substrat in der Vakuumkammer positioniert wird, die Vakuumkammer für 1-48 Stunden auf 80-110°C erhitzt wird.

4. Verfahren nach einem der vorhergehenden Patentansprüche, wobei in (i) Schritt, in dem das Substrat in der Vakuumkammer positioniert wird, das Substrat in eine Position gebracht wird, in der seine der Quelle zugewandte Oberfläche in einem Winkel von 30-70° zu der Magnetron- und Yttriumquelle steht.

5. Verfahren nach einem der vorhergehenden Patentansprüche, wobei das Prozessgas ein Gemisch aus Ar und O₂ ist.

6. Verfahren nach einem der vorhergehenden Patentansprüche, wobei das Prozessgas mit den folgenden Gasdurchsätzen in die Umhüllung zugeführt wird: P(Ar) / P(O₂): 500-800.

7. Verfahren nach einem der vorhergehenden Patentansprüche, wobei das Substrat vor seiner Positionierung in einer Vakuumkammer im Schritt (i) mit Aceton und Isopropanol in Ultraschallbädern gereinigt, mit destilliertem Wasser gespült und dann unter eingeblasenem N₂-Gas getrocknet wird.

## Revendications

1. Procédé de dépôt d'un film de monoxyde d'yttrium (YO) sur un substrat par pulvérisation magnétron réactive, comprenant les étapes suivantes :
(i) positionnement d'un substrat dans une chambre à vide ayant un magnétron et une source d'yttrium pour des particules pulvérisées et un moyen d'enveloppe de gaz de procédé permettant d'envelopper partiellement le magnétron, le substrat ayant une surface orientée vers la source ;
(ii) fonctionnement du magnétron pour pulvériser des particules d'yttrium à partir de la source d'yttrium pour revêtir la surface de substrat, y compris introduction d'un gaz de procédé au moyen d'enveloppe ;
(iii) prélèvement et épuisement du gaz de la chambre à vide et création d'une pression de procédé entre 1×10⁻³ et 5×10⁻³ Torr avec une pression partielle en oxygène de 1,40×10⁻⁸ à 1,74×10⁻⁵ Torr en faisant entrer les gaz de procédé et en continuant la pulvérisation de particules d'yttrium à partir de la source d'yttrium ; dès que l'épaisseur souhaitée de revêtement sur la surface de substrat est atteinte, désactivation du magnétron.

2. Procédé selon la revendication 1, dans lequel la pulvérisation de particules d'yttrium à partir de la source d'yttrium à l'étape (ii) est faite à la température de 290 à 630 K.

3. Procédé selon de quelconques revendications précédentes, dans lequel avant l'étape (i) de positionnement du substrat dans la chambre à vide, la chambre à vide est chauffée pendant 1 à 48 heures à 80 à 110 °C.

4. Procédé selon de quelconques revendications précédentes, dans lequel à l'étape (i) de positionnement du substrat dans une chambre à vide, le substrat est positionné de sorte que sa surface orientée vers la source est localisée selon un angle de 30 à 70° par rapport au magnétron et à la source d'yttrium.

5. Procédé selon de quelconques revendications précédentes, dans lequel le gaz de traitement est un mélange d'Ar et d'O₂.

6. Procédé selon de quelconques revendications précédentes, dans lequel le gaz de traitement est introduit dans le moyen d'enveloppe avec les débits de gaz suivants : P(Ar) / P(O₂) : 500 à 800.

7. Procédé selon de quelconques revendications précédentes, dans lequel avant positionnement du substrat dans une chambre à vide à l'étape (i) le substrat est nettoyé avec de l'acétone et de l'isopropanol dans des bains à ultrasons, rincé avec de l'eau distillée, puis séché sous N₂ gazeux soufflé.
